# EUROPEAN PATENT SPECIFICATION

(11) **EP 4 343 373 B1**
(45) Date of publication and mention of the grant of the patent: **14.01.2026**
(21) Application number: 23197108.6
(22) Date of filing: 13.09.2023
(51) Int. Cl.: G01S 7/481, G01S 7/487, G01S 7/497, G01S 17/894

(54) **IMAGE SENSING APPARATUS, ELECTRONIC APPARATUS INCLUDING THE SAME, AND DRIVING METHOD OF IMAGE SENSING APPARATUS**
BILDERFASSUNGSVORRICHTUNG, ELEKTRONISCHE VORRICHTUNG DAMIT UND ANSTEUERUNGSVERFAHREN FÜR BILDERFASSUNGSVORRICHTUNG
APPAREIL DE DÉTECTION D'IMAGE, APPAREIL ÉLECTRONIQUE LE COMPRENANT ET PROCÉDÉ DE COMMANDE D'APPAREIL DE DÉTECTION D'IMAGE

(30) Priority: 21.09.2022 KR 20220119482; 03.07.2023 KR 20230085519
(43) Date of publication of application: 27.03.2024
(73) Proprietor: LX Semicon Co., Ltd., Daejeon 34027 (KR)
(72) Inventor: HAN, Dong Su, 34027 Daejeon (KR); KIM, Jung Whan, 34027 Daejeon (KR); PARK, Seong Hong, 34027 Daejeon (KR)
(74) Representative: Goddar, Heinz J.

(56) References cited:
- KR-A- 20210 096 827
- US-A1- 2012 075 214
- US-A1- 2022 066 036

## Description

### BACKGROUND OF THE DISCLOSURE

### TECHNICALFIELD

The present disclosure relates to an image sensing apparatus, an electronic apparatus including the same, and a driving method of the image sensing apparatus.

### BACKGROUND

An image sensor is a device that converts an optical image into an electrical signal. Recently, with the development of computer industry and communications industry, demand for image sensors has increased in various fields such as digital cameras, camcorders, personal communication systems (PCSs), game devices, security cameras, medical micro cameras, and robot vacuum cleaners.

Image sensors typically measure a depth using the triangulation, Time of Flight (ToF), and interferometry methods, of which the ToF method has a wide application range and fast processing speed, and is also advantageous in terms of cost. An image sensor based on the ToF calculates a distance to a target object by measuring a time until a pulse-shaped optical signal emitted from a light source is reflected by the target object and returns, and accordingly, an image for the depth of the target object is generated.

This image sensor includes a diffuser that is located in a path in which an optical signal is emitted and incident and spreads the optical signal in a Field of View (FoV) area, a transparent electrode determining damage, cracks, or separation of the diffuser is applied on the diffuser, and a transparent electrode film shielding electromagnetic interference noise radiated through the path through which the optical signal is emitted and incident may be applied on the diffuser. The transparent electrode determining damage, cracks, or separation of the diffuser and the transparent electrode film shielding electromagnetic interference noise are implemented as separate components.
US 2022/066036 A1 describes a housing for an electro-optical device comprises a molded dielectric structural component, an electromagnetic interference (EMI) shield, and a plurality of conductive traces. The molded dielectric structural component may be configured to separate the EMI shield and the plurality of conductive traces.
KR 2021 0096827 A describes a camera module including a circuit board; a light source and an image sensor disposed on the circuit board; a housing disposed on the circuit board; a diffuser disposed on the light source and including an electrode; and a conductive part disposed in the housing and electrically connecting the electrode of the diffuser and the circuit board.

### SUMMARY

The present invention is defined by the subject matter of the appended independent claims. Particular embodiments are given by the features of the appended dependent claims.

### BRIEF DESCRIPTION OF THE DRAWINGS

In the drawings:
FIG. 1 is a block diagram of an electronic apparatus including an image sensing apparatus according to an embodiment of the present disclosure;
FIG. 2 is a perspective view of an image sensing apparatus according to an embodiment of the present disclosure;
FIG. 3 is a block diagram of an image sensing apparatus according to an embodiment of the present disclosure;
FIG. 4 is a plan view of a transparent electrode according to an embodiment of the present disclosure;
FIG. 5 is a circuit diagram of a transparent electrode driver according to an embodiment of the present disclosure;
FIG. 6A is a circuit diagram showing a state in which a transparent electrode driver is driven in a first mode according to an embodiment of the present disclosure;
FIG. 6B is a circuit diagram showing a state in which a transparent electrode driver is driven in a second mode according to an embodiment of the present disclosure;
FIG. 7 is a circuit diagram of a transparent electrode driver according to another embodiment of the present disclosure; and
FIG. 8 is a flowchart of driving of a light source and a transparent electrode driver according to an embodiment of the present disclosure.

### DETAILED DESCRIPTION

Throughout the specification, like reference numerals are used to refer to substantially the same components. In the following description, detailed descriptions of components and features known in the art may be omitted if they are not relevant to the core configuration of the present disclosure. The meanings of terms used in this specification are to be understood as follows.

The advantages and features of the present disclosure, and methods of achieving them, will become apparent from the detailed description of the embodiments, together with the accompanying drawings. However, the present disclosure is not limited to the embodiments disclosed herein and will be implemented in many different forms. The embodiments are provided merely to make the disclosure of the present disclosure thorough and to fully inform one of ordinary skill in the art to which the present disclosure belongs of the scope of the disclosure. It is to be noted that the scope of the present disclosure is defined only by the claims.

The figures, dimensions, ratios, angles, numbers of elements given in the drawings are merely illustrative and are not limiting. Like reference numerals refer to like elements throughout the specification. Further, in describing the present disclosure, descriptions of well-known technologies may be omitted in order to avoid obscuring the gist of the present disclosure.

As used herein, the terms "includes," "has," "comprises," and the like should not be construed as being restricted to the means listed thereafter unless specifically stated otherwise. Where an indefinite or definite article is used when referring to a singular noun e.g. "a" or "an", "the", this includes a plural of that noun unless something else is specifically stated.

Elements are to be interpreted a margin of error, even if not explicitly stated otherwise.

In describing positional relationships, for example, when a positional relationship between two parts is described as "on", "above", "below", "next to", and the like unless "immediately" or "directly" is used, one or more other portions may be placed between the two portions.

In describing temporal relationships, terms such as "after," "subsequent to," "next to," "before," and the like may include cases where any two events are not consecutive, unless the term "immediately" or "directly" is explicitly used.

While the terms first, second, and the like are used to describe various elements, the elements are not limited by these terms. These terms are used merely to distinguish one element from another. Accordingly, a first element referred to herein may be a second element within the technical idea of the present disclosure.

It should be understood that the term "at least one" includes all possible combinations of one or more related items. For example, the phrase "at least one of the first, second, and third items" can mean each of the first, second, or third items, as well as any possible combination of two or more of the first, second, and third items.

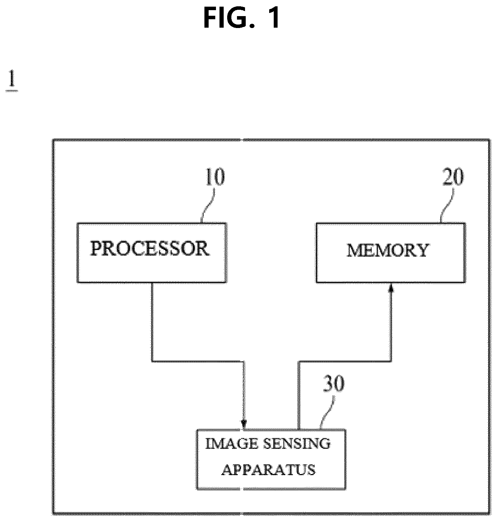

Hereinafter, with reference to FIGS. 1 to 6, a display device according to an embodiment of the present disclosure will be described in detail.

FIG. 1 is a block diagram of an electronic apparatus including an image sensing apparatus according to an embodiment of the present disclosure.

The electronic apparatus including the image sensing apparatus according to an embodiment of the present disclosure may be, for example, a robot vacuum cleaner, a medical device, an automobile, or a distance measuring device, but is not limited thereto, and the electronic apparatus may be a computer system, a camera system, a navigation system, a video phone, a supervision system, a tracking system, a motion surveillance system, or an image stabilization system.

As shown in FIG. 1, an electronic apparatus 1 including an image sensing apparatus 30 according to an embodiment of the present disclosure may include the image sensing apparatus 30, a processor 10, and a memory 20. Although not shown, the electronic apparatus 1 may further include an interface that is connected to a bus and communicates with the outside. Here, the interface may be, for example, an I/O interface or a wireless interface.

The image sensing apparatus 30 may be integrated with the processor 10 and the memory 20, which will be described later, or only the image sensing apparatus 30 may be integrated into a separate integrated circuit chip or may be mounted on a single printed circuit board.

The image sensing apparatus 30 may emit a first optical signal EL to an object based on Time of Flight (ToF) technology, receive a second optical signal RL reflected from the object, and calculate pixel data that is data about a distance between the image sensing apparatus 30 and the object based on the received second optical signal RL.

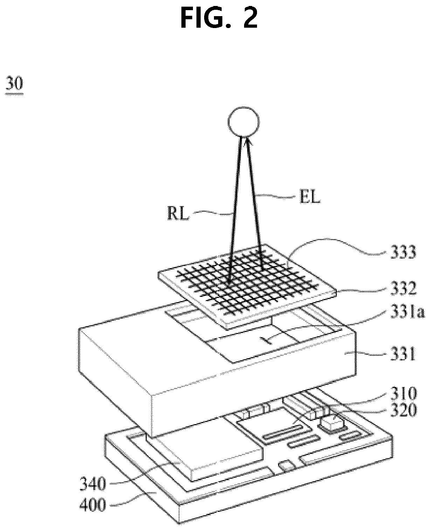

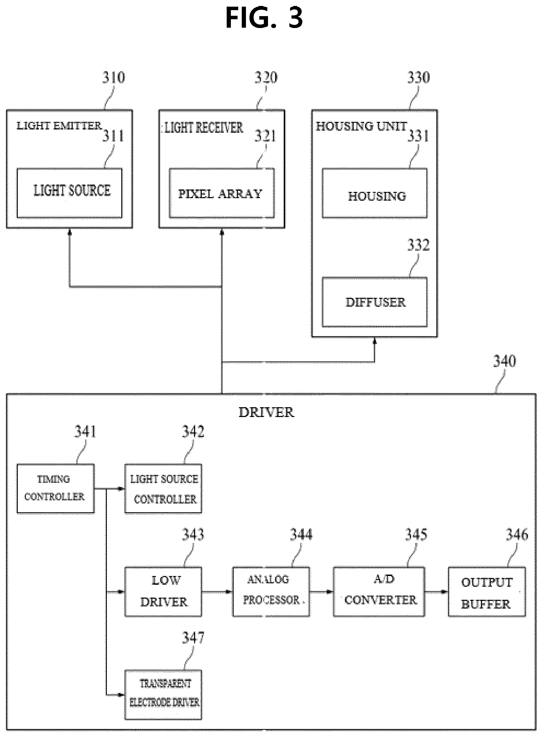

FIG. 2 is a perspective view of an image sensing apparatus according to an embodiment of the present disclosure. FIG. 3 is a block diagram of an image sensing apparatus according to an embodiment of the present disclosure.

As shown in FIGS. 2 and 3, the image sensing apparatus 30 includes a light emitter 310, a light receiver 320, a housing 331, a diffuser 332, a transparent electrode 333, a driver 340, and a substrate 400.

The light emitter 310 may be disposed on the substrate 400 and may generate the first optical signal EL and emit the first optical signal EL to an object. The light emitter 310 includes a light source 311.

The light source 311 may generate and output the first optical signal EL. The first optical signal EL output from the light source 311 may be infrared light with a wavelength of 770 nm to 3000 nm. Alternatively, the first optical signal EL output from the light source 311 may be visible light with a wavelength of 380 nm to 770 nm. The present disclosure is not limited thereto, and the light source 311 may generate a plurality of first optical signals EL with different frequencies, and may sequentially and repeatedly generate the plurality of first optical signals EL with different frequencies. Additionally, the light source 311 may simultaneously generate the plurality of first optical signals EL with different frequencies.

The light source 311 may generate and output the first optical signal EL in the form of a pulse wave or a continuous wave. The continuous wave may be in the form of a sinusoid wave or a square wave.

The light source 311 emits the generated first optical signal EL to the object for a certain integration time. For example, when the image sensing apparatus 30 captures an object at 20 FPS, the integration time is 1/20 [sec].

The light source 311 may include various elements that generate and output the first optical signal EL. For example, the light source 311 may include a light emitting diode (LED) or a vertical light emitting diode (VCSEL). Additionally, the light source 311 may include a plurality of light emitting diodes arranged according to a certain pattern. The present disclosure is not limited thereto, and the light source 311 may include an organic light emitting diode (OLED) or a laser diode (LD).

The light receiver 320 is located adjacent to the light emitter 310 on the substrate 400, receives the second optical signal RL emitted from the light emitter 310 and reflected from the object, and converts the received second optical signal RL into an electrical signal. The light receiver 320 may be arranged in the same direction as the light emitter 310, and thus reception efficiency of the second optical signal RL may be improved. The light receiver 320 includes a pixel array 321 that receives the second optical signal RL and converts the second optical signal RL into an electrical signal.

The pixel array 321 may be formed inside or above the substrate 400. Although not shown, the pixel array 321 may include a plurality of pixels, and the plurality of pixels of the pixel array 321 may be arranged in a matrix form. However, the present disclosure is not limited thereto, this is just one example, and the number of pixels constituting the pixel array 321 and the arrangement of the pixels may be changed in various ways.

Each pixel of the pixel array 321 may detect light of a wavelength corresponding to the wavelength of light output from the light emitter 310. For example, each pixel in the pixel array 321 may detect infrared light. Alternatively, each pixel of the pixel array 321 may detect visible light. However, the present disclosure is not limited thereto, and the pixel array 321 may detect the second optical signal RL of various wavelengths.

The pixel array 321 may receive the second optical signal RL during an integration time and generate an electrical signal therefor. To this end, the pixel array 321 includes a plurality of pixels. The pixel array 321 may detect the second optical signal RL reflected from an object and output pixel signals. In detail, each pixel of the pixel array 321 may generate, store, transmit, or remove charges based on control signals provided from a low driver 343, and convert the second optical signal RL, which is reflected from the object and input, into a pixel signal that is an electrical signal.

The housing 331 may be combined with the substrate 400 on which the light emitter 310 and the light receiver 320 are mounted, and may surround the light emitter 310 and the light receiver 320 together with the substrate 400.

The housing 331 may include an optical path hole 331a in an optical path through which the first optical signal EL emitted from the light emitter 310 is emitted to the object and the second optical signal RL reflected from the object is incident on the light receiver 320.

Although not shown, the housing 331 may further include a structure for efficiently emitting the first optical signal EL emitted from the light emitter 310 and efficiently receiving the second optical signal RL reflected from an object at the light receiver 320. For example, the housing 331 may further include a fixing member for optical axis alignment or an elastic member for moving an optical axis. Although not shown, the housing 331 may further include a fastening structure to effectively protect and shield the light emitter 310, the light receiver 320, and the driver 340. For example, the housing 331 may further include a fastening structure such as a screw and a bolt structure or a clamp structure to be effectively fastened to the substrate 400.

The diffuser 332 may diffuse the first optical signal EL emitted from the light emitter 310 to a Field of View (FoV) area and detect objects located within the FoV area to be detected. Because the diffuser 332 diffuses the first optical signal EL, the first optical signal EL emitted from the light emitter 310 may not be directly incident on the human eye.

The diffuser 332 may be located in the optical path hole 331a of the housing 331 and may be placed on the optical path of the first optical signal EL emitted from the light emitter 310 and the second optical signal RL received by the light receiver 320. The first optical signal EL emitted from the light source 311 may be incident on the object through the diffuser 332.

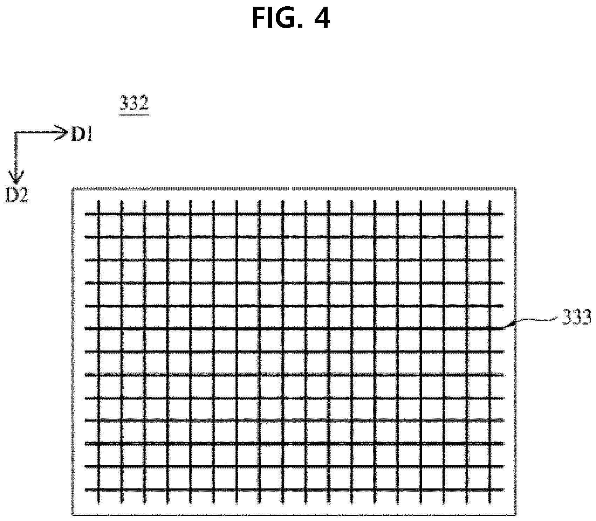

FIG. 4 is a plan view of a transparent electrode according to an embodiment of the present disclosure.

According to an embodiment of the present disclosure, as shown in FIG. 4, the transparent electrode 333 may be disposed on the diffuser 332 in the form of a mesh extending in a first direction D1 and a second direction D2. However, the present disclosure is not limited thereto, and the transparent electrode 333 may be formed in various forms that determines damage, cracks, or separation of the diffuser 332. For example, the transparent electrode 333 may extend in the first direction D1 or the second direction D2, or may extend in a direction at a predetermined angle with the first direction D1 or the second direction D2. Alternatively, the transparent electrode 333 may be formed to cover a front surface of the diffuser 332.

The transparent electrode 333 may be made of a transparent electrode material such that the first optical signal EL is emitted from the light emitter 310 to the object and the second optical signal RL reflected from the object is received by the light receiver 320. For example, the transparent electrode 333 is made of indium tin oxide (ITO), indium zinc oxide (IZO), zinc oxide (ZnO), indium zinc tin oxide (IZTO), cadmium tin oxide (CTO), poly(3,4-ethylenedioxythiophene) (PEDOT), carbon nanotubes (CNT), and metal wire alone or in a mixture of two or more.

Although not shown, the transparent electrode 333 may be electrically connected to the driver 340, and in particular, according to an embodiment of the present disclosure, depending on a driving mode of the image sensing apparatus 30, because the transparent electrode 333 is formed on the diffuser 332, a resistance value of the transparent electrode 333 changes and a voltage applied to the transparent electrode 333 changes in the case of damage, cracks, or separation of the diffuser 332, and thus damage, cracks, or separation of the diffuser 332 may be detected using the voltage applied to the transparent electrode 333, and the image sensing apparatus 30 may be driven to remove electromagnetic interference noise through ground by connecting the transparent electrode 333 to ground.

The driver 340 may control the light emitter 310 to output the first optical signal EL, control the light receiver 320 to receive the second optical signal RL reflected from the object, and detect a phase difference between the first optical signal EL output from the light emitter 310 and the second optical signal RL reflected from the object and input to the light receiver to calculate pixel data.

The driver 340 may include a timing controller 341, a light source controller 342, the low driver 343, an analog processing unit 344, an analog digital converter 345, an output buffer unit 346, and a transparent electrode driver 347, which are disposed above the substrate 400.

According to an embodiment of the present disclosure, the transparent electrode driver 347 may be included in a first unit circuit UC1, and the first unit circuit UC1 including the transparent electrode driver 347 may further include at least one of the timing controller 341, the light source controller 342, the low driver 343, the analog processing unit 344, the analog digital converter 345, and the output buffer unit 346. For example, the first unit circuit UC1 including the transparent electrode driver 347 may include the timing controller 341, the light source controller 342, the low driver 343, the analog processing unit 344, the analog digital converter 345, the output buffer unit 346, and the transparent electrode driver 347 or may also include the timing controller 341 and the transparent electrode driver 347. In this case, the first unit circuit UC1 may be implemented as a single integrated circuit chip, or may be implemented as a plurality of integrated circuit chips mounted on a single printed circuit board.

The timing controller 341 may output a signal controlling the light source 311 through the light source controller 342, and a control controlling the pixel array 321, the analog processing unit 344, the analog digital converter 345, and the output buffer unit 346 through the low driver 343, based on control of the processor 10. According to an embodiment of the present disclosure, depending on a driving mode of the image sensing apparatus 30 based on control of the processor 10, for example, prior to driving of the light source 311, the timing controller 341 may generate a transparent electrode control signal including a first mode driving signal driving the transparent electrode 333 in a first mode M1 to check whether damage, cracks, or separation of the diffuser 332 occur and a second mode driving signal driving the transparent electrode 333 in a second mode M2 to shield electromagnetic interference noise and output the transparent electrode control signal to the transparent electrode driver 347.

The light source controller 342 may control the light source 311 based on control of the timing controller 341. In detail, the light source controller 342 may modulate the first optical signal EL with a predetermined frequency and phase based on control of the processor 10 and control the light source 311 to emit the modulated first optical signal EL. For example, the modulated first optical signal EL may have the form of a square wave (pulse) or a sinusoidal wave and may be infrared light, microwave, light wave, or ultrasonic wave.

To efficiently emit the first optical signal EL toward an object, before driving the light source 311, the light source controller 342 may initialize the light source 311 and adjust the int intensity of the light source 311 to be turned on or may output an optical source initialization signal to the light emitter 310 to initialize the light source 311 by adjusting an optical axis of the light source 311.

Although FIG. 3 shows the case in which the light source controller 342 is included in the driver 340, but the present disclosure is not limited thereto, and the light source controller 342 may constitute the light emitter 310 together with the light source 311.

The low driver 343 may generate signals for controlling pixels based on control of the timing controller 341 and transmit the signals to the pixels. Specifically, the low driver 343 may generate control signals for selecting and driving a row of the pixel array 321, and for example, the low driver 343 may generate a selection signal, a reset signal, and a transmission signal and transmit the generated signals to pixels corresponding to the selected row.

To efficiently receive the second optical signal RL, which is received by reflecting the first optical signal EL emitted by the light emitter 310 from an object, the low driver 343 may initialize the pixel array 321 of the light receiver 320 together when initializing the light source 311 of the light emitter 310.

The analog processing unit 344 may receive, sample, and hold a pixel signal output from each pixel constituting the pixel array 321. The analog processing unit 344 may be connected to each pixel of the pixel array 321 and may perform a correlated double sampling (CDS) operation on a pixel signal and remove noise included in the pixel signal.

The analog digital converter 345 may convert pixel signals processed by the analog processing unit 344 into pixel data that is a digital signal. The analog digital converter 345 may provide the pixel data to the output buffer unit 346. Although FIG. 3 shows the case in which the analog processing unit 344 and the analog digital converter 345 are independent components, the analog digital converter 345 may be included in the analog processing unit 344 or integrated thereinto, according to another embodiment.

The output buffer unit 346 may store pixel data transmitted from the analog digital converter 345. The output buffer unit 346 may output the stored pixel data to the processor 10.

Although FIG. 3 shows the case in which the low driver 343, the analog processing unit 344, the analog digital converter 345, and the output buffer unit 346 are included in the driver 340, the present disclosure is not limited thereto, and at least one of the low driver 343, the analog processing unit 344, the analog digital converter 345, and the output buffer unit 346 may constitute the light receiver 320 with the pixel array 321.

To check whether damage, cracks, or separation of the diffuser 332 occur before the light source 311 is driven, a transparent electrode control signal including a first mode driving signal driving the transparent electrode 333 in a first mode and the second mode driving signal driving the transparent electrode 333 in a second mode to shield electromagnetic interference noise may be generated and output to the transparent electrode driver 347.

The transparent electrode driver 347 drives the transparent electrode 333 according to a mode of the image sensing apparatus 30 to detect whether damage, cracks, and separation of the diffuser 332 occur or shield electromagnetic interference noise. In detail, before the light source 311 is driven, the transparent electrode driver 347 may be driven in the first mode M1 to check whether damage, cracks, or separation of the diffuser 332 occur in an initialization stage of the light source 311 and may drive the transparent electrode 333 according to the first mode driving signal received from the timing controller 341, and when determining that damage, cracks, or separation of the diffuser 332 do not occur, the transparent electrode driver 347 may be driven in the second mode M2 and may drive the transparent electrode 333 according to the second mode driving signal received from the timing controller 341 to shield electromagnetic interference noise. Then, the light emitter 310 and the light receiver 320 may be driven to emit the first optical signal EL and receive the second optical signal RL reflected from the object. In this case, to continuously shield electromagnetic interference noise even while the light emitter 310 and the light receiver 320 are driven, the transparent electrode driver 347 may be driven in the second mode M2.

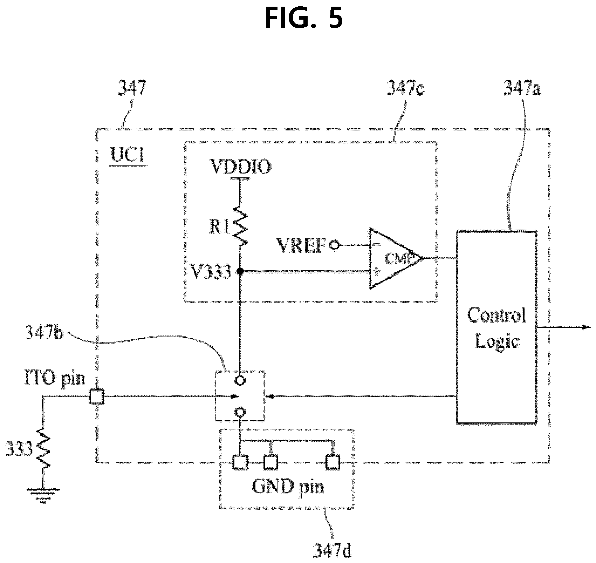

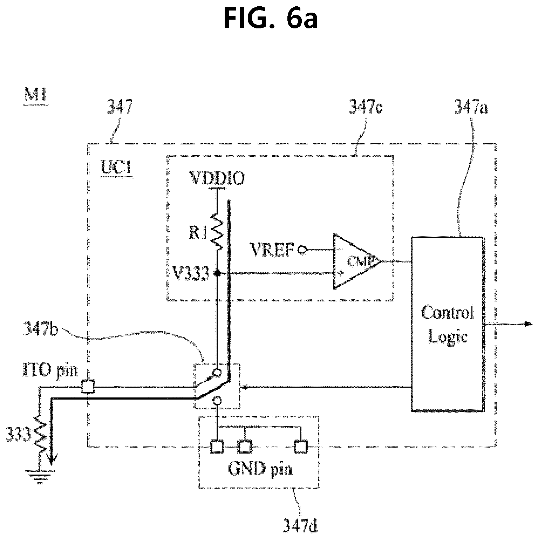

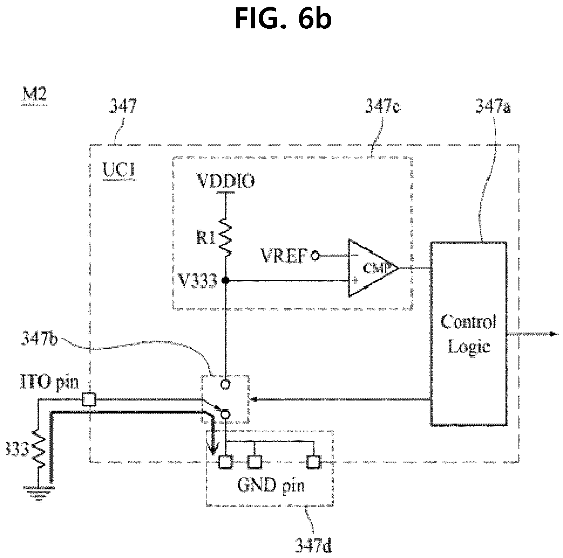

FIG. 5 is a circuit diagram of a transparent electrode driver according to an embodiment of the present disclosure. FIG. 6A is a circuit diagram showing a state in which a transparent electrode driver is driven in a first mode according to an embodiment of the present disclosure. FIG. 6B is a circuit diagram showing a state in which a transparent electrode driver is driven in a second mode according to an embodiment of the present disclosure.

According to an embodiment of the present disclosure, as shown in FIG. 5, the transparent electrode driver 347 may include a control circuit 347a, a mode switch 347b, a voltage comparison circuit 347c, and a ground line 347d. In this case, the transparent electrode driver 347 may be connected to the transparent electrode 333 located above the diffuser 332 through a transparent electrode pin ITO pin of the first unit circuit UC1, and the first unit circuit UC1 may be connected to ground through a ground pin GND pin of the first unit circuit UC1.

The control circuit 347a operates the transparent electrode driver 347 in either the first mode M1 or the second mode M2. In one embodiment, the control circuit 347a may control the mode switch 347b according to a transparent electrode control signal output from the timing controller 341 and an output signal of the voltage comparison circuit 347c to operate the transparent electrode driver 347 in any one of the first mode M1 and the second mode M2.

When receiving the first mode driving signal output from the timing controller 341, the control circuit 347a operates the transparent electrode driver 347 in the first mode M1. In detail, when receiving the first mode driving signal, as shown in FIG. 6A, the control circuit 347a may transmit a voltage comparison circuit connection signal to the mode switch 347b, and the mode switch 347b may be driven to electrically connect the transparent electrode 333 to the voltage comparison circuit 347c. Thus, a voltage applied to the transparent electrode 333 and a reference voltage VREF are compared with each other by the voltage comparison circuit 347c, and the control circuit 347a receives the comparison result and determines whether the diffuser 332 is damaged. Alternatively, through the control circuit 347a, the timing controller 341 may receive the comparison result and may also determine whether the diffuser 332 is damaged.

The control circuit 347a may operate the transparent electrode driver 347 in the second mode M2 according to the output signal output from the voltage comparison circuit 347c. In detail, when the control circuit 347a determines whether the diffuser 332 is damaged and determines that the diffuser 332 is not damaged, the transparent electrode driver 347 may be driven to operate in the second mode M2. Alternatively, when the timing controller 341 receives the output signal output from the voltage comparison circuit 347c through the control circuit 347a and determines whether the diffuser 332 is damaged, if the timing controller 341 determines that the diffuser 332 is not damaged and output the second mode driving signal to the control circuit 347a, the transparent electrode driver 347 may be driven to operate in the second mode M2.

When the transparent electrode driver 347 is driven in the second mode M2, the control circuit 347a may transmit a ground line connection signal to the mode switch 347b, and thus, the mode switch 347b may electrically connect the transparent electrode 333 to the ground line 347d.

When a voltage V333 applied to the transparent electrode 333 is smaller than the reference voltage VREF and it is determined that the diffuser 332 is not damaged, the control circuit 347a may be driven in the second mode M2 and may output the ground line connection signal to the mode switch 347b to connect the transparent electrode 333 to the ground line 347d, as shown in FIG. 6B. When the voltage V333 applied to the transparent electrode 333 is larger than the reference voltage VREF and it is determined that the diffuser 332 is damaged, the control circuit 347a may be driven to stop operations of the light emitter 310 and the light receiver 320. In detail, the timing controller 341 may receive a drive stop signal from the control circuit 347a and output a signal for stopping an operation of each of the light emitter 310 and the light receiver 320. Alternatively, the timing controller 341 may receive the comparison result from the voltage comparison circuit 347c through the control circuit 347a, determine that the diffuser is damaged, and output a signal for stopping operations of the light emitter 310 and the light receiver 320 to the light source controller 342, and accordingly, each of the light emitter 310 and the light receiver 320 may receive the drive stop signal from the control circuit 347a and stop operating.

As described above, the mode switch 347b may connect the transparent electrode 333 to the voltage comparison circuit 347c or the ground line 347d depending on a mode according to a switch control signal including the voltage comparison circuit connection signal and ground line connection signal received from the control circuit 347a. As shown in FIG. 6A, the mode switch 347b may receive the voltage comparison circuit connection signal in the first mode M1 and may electrically connect the transparent electrode 333 to the voltage comparison circuit 347c, and as shown in FIG. 6B, the mode switch 347b may receive the ground line connection signal in the second mode M2 and may electrically connect the transparent electrode 333 to the ground line 347d. In this case, the transparent electrode 333 may be connected to the mode switch 347b to the voltage comparison circuit 347c through the transparent electrode pin ITO pin of the first unit circuit UC1 including the transparent electrode driver 347. The ground line 347d may be connected to the external ground of the first unit circuit UC1 including the transparent electrode driver 347 through a ground pin GND pin of the first unit circuit UC1 including the transparent electrode driver 347.

As shown in FIG. 6A, the voltage comparison circuit 347c may be connected to the transparent electrode 333 through the mode switch 347b in the first mode M1, may receive and compare the reference voltage VREF and the voltage V333 applied to the transparent electrode 333, and may output the comparison result. To this end, the voltage comparison circuit 347c may include a first resistor R1 and a comparer CMP.

The first resistor R1 may be connected to an input and output power voltage VDDIO and the transparent electrode 333 in the first mode M1. In detail, as shown in FIG. 6A, in the first mode M1, a first terminal of the first resistor R1 is connected to the input and output power voltage VDDIO, and a second terminal is connected to the transparent electrode 333 through the mode switch 347b and the transparent electrode pin ITO pin. Thus, in the first mode M1, the input and output power voltage VDDIO is distributed and applied to the first resistor R1 and the transparent electrode 333.

The comparer CMP may compare the reference voltage VREF with the voltage V333 applied to the transparent electrode 333 and output the comparison result to the control circuit 347a. In detail, the comparer CMP receives the reference voltage VREF through a first input terminal "-", receives the voltage V333 applied to the transparent electrode 333 through a second input terminal "+", compare the reference voltage VREF with the voltage V333 applied to a transparent electrode, and output the comparison result to the control circuit 347a.

The ground line 347d may be a wire connected to the ground, and may be connected to external ground of the first unit circuit UC1 including the transparent electrode driver 347 through the ground pin GND pin of the first unit circuit UC1 including the transparent electrode driver 347. As shown in FIG. 6B, in the second mode M2, the ground line 347d may be electrically connected to the transparent electrode 333 through the transparent electrode pin ITO pin of the first unit circuit UC1 to emit electromagnetic interference noise to ground through the transparent electrode 333.

Referring back to FIG. 1, the processor 10 may control the image sensing apparatus 30. In detail, the processor 10 may control the light emitter 310 to output the first optical signal EL with a predetermined frequency and a predetermined phase and may control the light receiver 320 to detect the second optical signal RL reflected from an object and generate pixel data.

The processor 10 may calculate a distance (e.g., ToF value) between the image sensing apparatus 30 and an object, a shape of the object, a moving speed, and the like based on pixel data generated using the frequency and phase of the first optical signal EL output from the light emitter 310 and the frequency and phase of the second optical signal RL input to the light receiver 320.

For example, the processor 10 may calculate a phase difference between the first optical signal EL output from the light emitter 310 based on the pixel data generated by the image sensing apparatus 30 and the second optical signal RL reflected from the object and input to the light receiver 320 and may calculate a delay time of the second optical signal RL reflected from the object and input to the light receiver 320 compared to the first optical signal EL output from the light emitter 310 using the calculated phase difference.

The processor 10 may include an image signal processor (ISP) (not shown) for processing pixel data transmitted from the image sensing apparatus 30. The processor 10 may also be referred to as a host, a sensor controller, or the like.

As shown in FIG. 1, the processor 10 may be implemented separately from the image sensing apparatus 30. However, the present disclosure is not limited thereto, and the processor 10 may be integrated with the image sensing apparatus 30 and implemented as a single integrated circuit chip.

The memory 20 may receive pixel data output from the image sensing apparatus 30 and store the pixel data. To this end, the memory 20 may include a volatile and/or non-volatile memory.

The memory 20 may store commands or data related to at least one other component of the electronic apparatus 1. For example, the memory 20 may store software and/or a program. The program may include, for example, a kernel, middleware, an application programming interface (API), and/or an application program. At least part of the kernel, middleware, and API may be referred to as an operation system (OS).

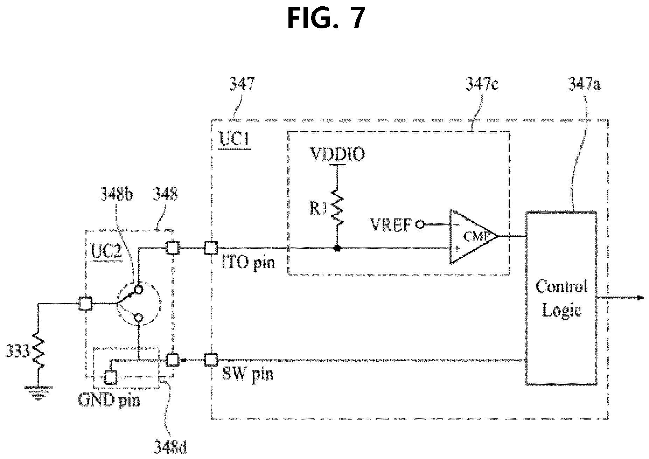

FIG. 7 is a circuit diagram of a transparent electrode driver according to another embodiment of the present disclosure.

According to another embodiment of the present disclosure, as shown in FIG. 7, the first unit circuit UC1 may include a control circuit 347a and the voltage comparison circuit 347c, and a second unit circuit UC2 may include a ground line 347d and a mode switch 348c. In this case, the first unit circuit UC1 may include at least one of the timing controller 341, the light source controller 342, the low driver 343, the analog processing unit 344, the analog digital converter 345, and the output buffer unit 346. In this case, the first unit circuit UC1 and the second unit circuit UC2 may each be implemented with one integrated circuit chip, or may be implemented with a plurality of integrated circuit chips mounted on one printed circuit board.

The first unit circuit UC1 including the transparent electrode driver 347 may further include the transparent electrode pin ITO pin and a switching pin SW pin, the voltage comparison circuit 347c included in the first unit circuit UC1 may be electrically connected to a mode switch 348b included in the second unit circuit UC2 through the transparent electrode pin ITO pin of the first unit circuit UC1, and the control circuit 347a included in the first unit circuit UC1 may be electrically connected to the mode switch 348b included in the second unit circuit UC2 through the switching pin SW pin.

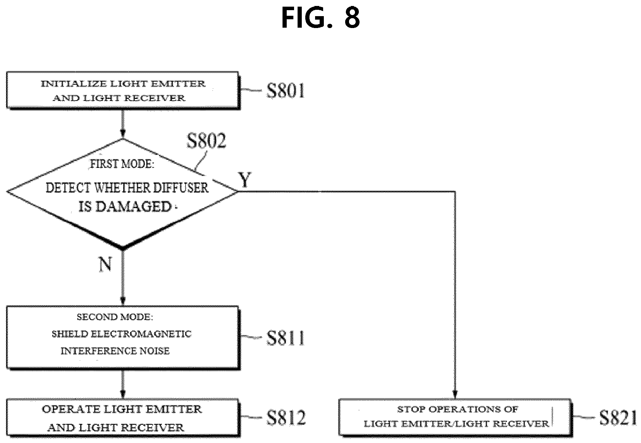

Hereinafter, a driving method of a light source and a transparent electrode driver will be described in detail with reference to FIG. 8.

FIG. 8 is a flowchart of driving of a light source and a transparent electrode driver according to an embodiment of the present disclosure.

After the light emitter 310 and the light receiver 320 are initialized, before the light emitter 310 and the light receiver 320 are driven, the transparent electrode driver 347 may be driven in the first mode M1 to check whether damage, cracks, or separation of the diffuser 332 occur using the transparent electrode 333, and when determining that damage, cracks, or separation of the diffuser 332 do not occur, the transparent electrode driver 347 may be driven in the second mode M2 to connect the transparent electrode 333 to ground and to shield electromagnetic interference noise, and then may drive the light emitter 310 and the light receiver 320.

In detail, referring to FIG. 8, first, the timing controller 341 initializes the light emitter 310 and the light receiver 320 (S801). In detail, the timing controller 341 may control the light source controller 342 to initialize the light source 311 of the light emitter 310 and initialize the pixel array 321 of the light receiver 320. For example, the timing controller 341 may control the light source controller 342, and the light source controller 342 may adjust the intensity of the light source 311 to be turned on or may initialize the light emitter 310 and the light receiver 320 by adjusting an optical axis to efficiently emit the first optical signal EL from the light emitter 310 toward an object and to efficiently receive the second optical signal RL reflected from the object by the light receiver 320.

Then, the light emitter 310 and the light receiver 320 are initialized, before the light emitter 310 and the driver 340 are driven, the transparent electrode driver 347 is driven in the first mode M1 to detect whether the diffuser 332 is damaged (S802). In detail, as shown in FIG. 6A, the voltage comparison circuit 347c and the transparent electrode 333 are connected to each other by the mode switch 347b that receives the voltage comparison circuit connection signal from the control circuit 347a, and the input and output power voltage VDDIO is applied to the transparent electrode 333 and the first resistor R1. The input and output power voltage VDDIO is distributed and applied to the first resistor R1 and the transparent electrode 333, the voltage V333 applied to the transparent electrode 333 is input to the comparer CMP through the second input terminal "+", and the reference voltage VREF is input to the comparer CMP through the first input terminal "-". The comparer CMP compares the reference voltage VREF input through the first input terminal "-" with the voltage V333 applied to the transparent electrode 333, input through the second input terminal "+", and outputs the comparison result to the control circuit 347a.

The control circuit 347a may receive the result obtained by comparing the reference voltage VREF with the voltage V333 applied to the transparent electrode 333, from the voltage comparison circuit 347c, determine whether the diffuser 332 is damaged, and drive the transparent electrode driver 347 to operate in the second mode or drive the light emitter 310 and the light receiver 320 to stop operating according to whether the diffuser 332 is damaged. Alternatively, the timing controller 341 receives an output signal output from the voltage comparison circuit 347c through the control circuit 347a and determines whether the diffuser 332 is damaged, and when the timing controller 341 determines that the diffuser 332 is not damaged and outputs the second mode driving signal to the control circuit 347a, the transparent electrode driver 347 may be driven to operate in the second mode M2.

When the voltage V333 applied to the transparent electrode 333 is smaller than the reference voltage VREF and it is determined that the diffuser 332 is not damaged, the control circuit 347a may be driven in the second mode M2 to output the ground line connection signal to the mode switch 347b to connect the transparent electrode 333 to the ground line 347d, as shown in FIG. 6B. When a voltage applied to the transparent electrode 333 is greater than the reference voltage VREF and it is determined that the diffuser 332 is damaged, the control circuit 347a may be driven to stop operations of the light emitter 310 and the light receiver 320.

As described above, when it is determined that the diffuser 332 is not damaged, the transparent electrode driver 347 is driven in the second mode M2 to shield electromagnetic interference noise (S811). Specifically, as shown in FIG. 6B, the ground line 347d and the transparent electrode 333 are connected by the mode switch 347b, which receives the ground line connection signal from the control circuit 347a, and electromagnetic interference noise may be removed through the transparent electrode 333 connected to the ground.

When the transparent electrode driver 347 is driven in the second mode M2, the light emitter 310 and the light receiver 320 may be driven to operate (S812). That is, while the transparent electrode driver 347 is driven in the second mode M2 to shield electromagnetic interference noise, the light emitter 310 and the light receiver 320 may operate to perform image sensing.

In contrast, as described above, when a voltage applied to the transparent electrode 333 is greater than the reference voltage VREF and it is determined that the diffuser 332 is damaged, the light emitter 310 and the light receiver 320 may be driven to stop operating (S821). In detail, the timing controller 341 may receive a drive stop signal from the control circuit 347a and output a signal for stopping an operation to each of the light emitter 310 and the light receiver 320. Alternatively, the timing controller 341 may receive the comparison result through the control circuit 347a from the voltage comparison circuit 347c to determine that the diffuser is damaged and output a signal for stopping operations of the light emitter 310 and the light receiver 320 to the light source controller 342, and each of the light emitter 310 and the light receiver 320 may receive a drive stop signal from the control circuit 347a and stop operating.

According to the present disclosure, the image sensing apparatus, the electronic apparatus including the same, and the driving method of the image sensing apparatus may not only detect damage, cracks, and separation of the diffuser in the first mode by using a transparent electrode located on the diffuser but also shield electromagnetic interference noise caused by high-frequency driving in the second mode.

According to the present disclosure, whether damage, cracks, or separation of the diffuser occur may be determined and electromagnetic interference noise may be shielded using a transparent electrode located on the diffuser, thereby reducing the volume and weight of the image sensing apparatus.

It will be appreciated by those skilled in the art to which the present disclosure belongs that the disclosure described above may be practiced in other specific forms without altering its technical ideas or essential features.

It should therefore be understood that the embodiments described above are exemplary and non-limiting in all respects. The scope of the present disclosure is defined by the appended claims.

## Claims

1. An image sensing apparatus (30) comprising:
a driver (340) disposed on a substrate (400) and configured to drive a light emitter (310) and a light receiver (320) to emit a first optical signal toward an object and receive a second optical signal reflected from the object;
a housing (331) coupled to the substrate and surrounding the light emitter (310), the light receiver (320), and the driver (340);
a diffuser (332) disposed on the housing (331); and
a transparent electrode (333) disposed on the diffuser (332),
wherein the driver (340) includes a transparent electrode driver (347) configured to detect whether the diffuser (332) is damaged in a first mode (M1) and shield electromagnetic interference noise in a second mode (M2) by using the transparent electrode (333),
**characterized in that**
the transparent electrode (333) is driven as the first mode (M1) according to a first mode driving signal, and driven as the second mode (M2) according to a second mode driving signal,
wherein a damage of the diffuser (332) is detected using a voltage applied to the transparent electrode (333) in the first mode (M1), and
wherein the electromagnetic interference noise is removed by connecting the transparent electrode (333) to a ground in the second mode (M2).

2. The image sensing apparatus of claim 1, wherein, before the light emitter (310) and the light receiver (320) are initialized and driven, the transparent electrode driver (347) is driven in the first mode (M1) to compare a voltage applied to the transparent electrode (333) with a reference voltage (VREF); and determine whether the diffuser (332) is damaged;
wherein, when it is determined that the diffuser (332) is damaged, the light emitter (310) and the light receiver (320) stop operating; and
wherein, when it is determined that the diffuser (332) is not damaged, the transparent electrode driver (347) is driven in the second mode (M2).

3. The image sensing apparatus of any of the preceding claims, wherein the transparent electrode driver (347) includes:
a voltage comparison circuit (347c) configured to detect whether the diffuser (332) is damaged;
a ground line (347d) connected to the ground;
a mode switch (347b) configured to connect the transparent electrode to any one of the voltage comparison circuit (347c) and the ground line (347d) depending on a driving mode; and
a control circuit (347a) configured to control the mode switch (347b) to connect the transparent electrode to any one of the voltage comparison circuit (347c) and the ground line (347d) depending on the driving mode.

4. The image sensing apparatus of claim 3, wherein, in the first mode (M1), the control circuit (347a) controls the mode switch (347b) to connect the transparent electrode (333) to the voltage comparison circuit (347c), and the voltage comparison circuit (347c) outputs, to the control circuit (347a), a comparison result obtained by comparing a voltage applied to the transparent electrode (333) with a reference voltage (VREF); and
wherein, when the voltage applied to the transparent electrode (333) is smaller than the reference voltage (VREF), the control circuit (347a) determines that the diffuser (332) is not damaged and drives the transparent electrode driver in the second mode (M2) of shielding electromagnetic interference noise; and
wherein, when the voltage applied to the transparent electrode (333) is greater than the reference voltage, the control circuit (347a) determines that the diffuser (332) is damaged and stops operations of the light emitter (310) and the light receiver (320).

5. The image sensing apparatus of claim 3 or 4, wherein, in the second mode, the control circuit (347a) controls the mode switch (347b) to connect the transparent electrode (333) to the ground line (347d).

6. The image sensing apparatus of any of claims 3 to 5, wherein the voltage comparison circuit (347c) includes a comparer configured to receive a reference voltage (VREF) through a first input terminal, receive a voltage applied to the transparent electrode (333) in the first mode through a second input terminal, compare the reference voltage (VREF) with the voltage applied to the transparent electrode, and output a comparison result to the control circuit (347a).

7. The image sensing apparatus of any of claims 3 to 6,
wherein a first unit circuit (UC1) includes the control circuit (347a), the voltage comparison circuit (347c), the mode switch (347b), and the ground line (347d); and
wherein the first unit circuit (UC1) is implemented as a circuit mounted on one integrated circuit chip or one circuit board.

8. The image sensing apparatus of any of claims 3 to 7, wherein a first unit circuit (UC1) includes the control circuit (347a) and the voltage comparison circuit (347c); wherein a second unit circuit (UC2) includes the mode switch (347b) and the ground line (347d); and wherein the first unit circuit (UC1) is implemented as a circuit mounted on one integrated circuit chip or one circuit board, and the second unit circuit (UC2) is implemented as a circuit mounted on another integrated circuit chip or another circuit board.

9. An image sensing method comprising:
initializing a light emitter (310) and a light receiver (320);
detecting whether a diffuser (332) is damaged using a transparent electrode (333) disposed on the diffuser (332) as a transparent electrode driver (347) is driven in a first mode (M1);
stopping operations of the light emitter (310) and the light receiver (320) when it is determined that the diffuser (332) is damaged; and
shielding electromagnetic interference noise and operating the light emitter (310) and the light receiver (320) as the transparent electrode driver (347) is driven in a second mode (M2) when it is determined that the diffuser (332) is not damaged,
**characterized in that**
the transparent electrode (333) is driven as the first mode according to a first mode driving signal, and driven as the second mode (M2) according to a second mode driving signal,
wherein a damage of the diffuser (332) is detected using a voltage applied to the transparent electrode (333) in the first mode (M1), and
wherein the electromagnetic interference noise is removed by connecting the transparent electrode (333) to a ground in the second mode (M2).

10. The image sensing method of claim 9,
wherein, in the detecting whether the diffuser (332) is damaged, a mode switch (347b) connects the transparent electrode to a voltage comparison circuit (347c) configured to compare a voltage applied to the transparent electrode (333) with a reference voltage (VREF).

11. The image sensing method of claim 10,
wherein, in the detecting whether the diffuser (332) is damaged, the voltage comparison circuit (347c) compares the voltage applied to the transparent electrode with the reference voltage (VREF), determines that the diffuser (332) is not damaged when the voltage applied to the transparent electrode is smaller than the reference voltage, and determines that the diffuser (332) is damaged when the voltage applied to the transparent electrode is greater than the reference voltage.

12. The image sensing method of any of claims 9 to 11,
wherein, in the shielding electromagnetic interference noise and operating the light emitter (310) and the light receiver (320) as the transparent electrode driver (347) is driven in the second mode (M2) when it is determined that the diffuser (332) is not damaged, a mode switch (347b) connects the transparent electrode to a ground line (347d).

13. The image sensing method of any of claims 9 to 12, wherein, in the detecting whether the diffuser (332) is damaged using the transparent electrode disposed on the diffuser (332) as the transparent electrode driver (347) is driven in the first mode (M1), a control circuit (347a) outputs a voltage comparison circuit (347c) connection signal to a mode switch (347b); and
wherein, in the shielding electromagnetic interference noise and operating the light emitter (310) and the light receiver (320) as the transparent electrode driver (347) is driven in the second mode (M2) when it is determined that the diffuser (332) is not damaged, the control circuit (347a) outputs a ground line connection signal to the mode switch (347b).

14. The image sensing method of any of claims 9 to 13, wherein the detecting whether the diffuser (332) is damaged using the transparent electrode disposed on the diffuser (332) as the transparent electrode driver (347) is driven in the first mode (M1) includes comparing a reference voltage (VREF) with a voltage applied to the transparent electrode (333) and detecting whether the diffuser (332) is damaged using a comparer configured to receive the reference voltage and receive the voltage applied to the transparent electrode in the first mode (M1) through a second input terminal.

## Patentansprüche

1. Bilderfassungsvorrichtung (30), umfassend:
einen Treiber (340), der auf einem Substrat (400) angeordnet ist und konfiguriert ist, um einen Lichtemitter (310) und einen Lichtempfänger (320) anzutreiben, um ein erstes optisches Signal in Richtung eines Objekts zu emittieren und ein zweites optisches Signal zu empfangen, das von dem Objekt reflektiert wird;
ein Gehäuse (331), das mit dem Substrat gekoppelt ist und den Lichtemitter (310), den Lichtempfänger (320) und den Treiber (340) umgibt;
einen Diffusor (332), der auf dem Gehäuse (331) angeordnet ist; und
eine transparente Elektrode (333), die auf dem Diffusor (332) angeordnet ist,
wobei der Treiber (340) einen transparenten Elektrodentreiber (347) umfasst, der konfiguriert ist, um zu erfassen, ob der Diffusor (332) in einem ersten Modus (M1) beschädigt ist, und elektromagnetisches Interferenzrauschen in einem zweiten Modus (M2) unter Verwendung der transparenten Elektrode (333) abzuschirmen,
**dadurch gekennzeichnet, dass**
die transparente Elektrode (333) als der erste Modus (M1) gemäß einem ersten Modusantriebssignal angetrieben wird und als der zweite Modus (M2) gemäß einem zweiten Modusantriebssignal angetrieben wird,
wobei eine Beschädigung des Diffusors (332) unter Verwendung einer Spannung erfasst wird, die an die transparente Elektrode (333) in dem ersten Modus (M1) angelegt wird, und
wobei das elektromagnetische Interferenzrauschen durch Verbinden der transparenten Elektrode (333) mit einer Masse in dem zweiten Modus (M2) entfernt wird.

2. Bilderfassungsvorrichtung nach Anspruch 1, wobei, bevor der Lichtemitter (310) und der Lichtempfänger (320) initialisiert und angetrieben werden, der transparente Elektrodentreiber (347) in dem ersten Modus (M1) angetrieben wird, um eine Spannung, die an die transparente Elektrode (333) angelegt wird, mit einer Referenzspannung (VREF) zu vergleichen; und zu bestimmen, ob der Diffusor (332) beschädigt ist;
wobei, wenn bestimmt wird, dass der Diffusor (332) beschädigt ist, der Lichtemitter (310) und der Lichtempfänger (320) den Betrieb stoppen; und
wobei, wenn bestimmt wird, dass der Diffusor (332) nicht beschädigt ist, der transparente Elektrodentreiber (347) in dem zweiten Modus (M2) angetrieben wird.

3. Bilderfassungsvorrichtung nach einem der vorhergehenden Ansprüche, wobei der transparente Elektrodentreiber (347) Folgendes umfasst:
eine Spannungsvergleichsschaltung (347c), die konfiguriert ist, um zu erfassen, ob der Diffusor (332) beschädigt ist;
eine Masseleitung (347d), die mit der Masse verbunden ist;
einen Modusschalter (347b), der konfiguriert ist, um die transparente Elektrode mit einer von der Spannungsvergleichsschaltung (347c) und der Masseleitung (347d) in Abhängigkeit von einem Antriebsmodus zu verbinden; und
eine Steuerschaltung (347a), die konfiguriert ist, um den Modusschalter (347b) zu steuern, um die transparente Elektrode mit einer von der Spannungsvergleichsschaltung (347c) und der Masseleitung (347d) in Abhängigkeit von dem Antriebsmodus zu verbinden.

4. Bilderfassungsvorrichtung nach Anspruch 3, wobei in dem ersten Modus (M1) die Steuerschaltung (347a) den Modusschalter (347b) steuert, um die transparente Elektrode (333) mit der Spannungsvergleichsschaltung (347c) zu verbinden, und die Spannungsvergleichsschaltung (347c) an die Steuerschaltung (347a) ein Vergleichsergebnis ausgibt, das durch Vergleichen einer Spannung, die an die transparente Elektrode (333) angelegt wird, mit einer Referenzspannung (VREF) erhalten wird; und
wobei, wenn die Spannung, die an die transparente Elektrode (333) angelegt wird, kleiner als die Referenzspannung (VREF) ist, die Steuerschaltung (347a) bestimmt, dass der Diffusor (332) nicht beschädigt ist, und den transparenten Elektrodentreiber in dem zweiten Modus (M2) zum Abschirmen von elektromagnetischem Interferenzrauschen antreibt; und
wobei, wenn die Spannung, die an die transparente Elektrode (333) angelegt wird, größer als die Referenzspannung ist, die Steuerschaltung (347a) bestimmt, dass der Diffusor (332) beschädigt ist, und den Betrieb des Lichtemitters (310) und des Lichtempfängers (320) stoppt.

5. Bilderfassungsvorrichtung nach Anspruch 3 oder 4, wobei in dem zweiten Modus die Steuerschaltung (347a) den Modusschalter (347b) steuert, um die transparente Elektrode (333) mit der Masseleitung (347d) zu verbinden.

6. Bilderfassungsvorrichtung nach einem der Ansprüche 3 bis 5, wobei die Spannungsvergleichsschaltung (347c) einen Komparator umfasst, der konfiguriert ist, um eine Referenzspannung (VREF) durch einen ersten Eingangsanschluss zu empfangen, eine Spannung, die an die transparente Elektrode (333) in dem ersten Modus angelegt wird, durch einen zweiten Eingangsanschluss zu empfangen, die Referenzspannung (VREF) mit der Spannung, die an die transparente Elektrode angelegt wird, zu vergleichen und ein Vergleichsergebnis an die Steuerschaltung (347a) auszugeben.

7. Bilderfassungsvorrichtung nach einem der Ansprüche 3 bis 6, wobei eine erste Einheitsschaltung (UC1) die Steuerschaltung (347a), die Spannungsvergleichsschaltung (347c), den Modusschalter (347b) und die Masseleitung (347d) umfasst; und
wobei die erste Einheitsschaltung (UC1) als eine Schaltung implementiert ist, die auf einem integrierten Schaltungschip oder einer Leiterplatte montiert ist.

8. Bilderfassungsvorrichtung nach einem der Ansprüche 3 bis 7, wobei eine erste Einheitsschaltung (UC1) die Steuerschaltung (347a) und die Spannungsvergleichsschaltung (347c) umfasst; wobei eine zweite Einheitsschaltung (UC2) den Modusschalter (347b) und die Masseleitung (347d) umfasst; und wobei die erste Einheitsschaltung (UC1) als eine Schaltung implementiert ist, die auf einem integrierten Schaltungschip oder einer Leiterplatte montiert ist, und die zweite Einheitsschaltung (UC2) als eine Schaltung implementiert ist, die auf einem anderen integrierten Schaltungschip oder einer anderen Leiterplatte montiert ist.

9. Bilderfassungsverfahren, umfassend:
Initialisieren eines Lichtemitters (310) und eines Lichtempfängers (320);
Erfassen, ob ein Diffusor (332) beschädigt ist, unter Verwendung einer transparenten Elektrode (333), die auf dem Diffusor (332) angeordnet ist, während ein transparenter Elektrodentreiber (347) in einem ersten Modus (M1) angetrieben wird;
Stoppen des Betriebs des Lichtemitters (310) und des Lichtempfängers (320), wenn bestimmt wird, dass der Diffusor (332) beschädigt ist; und
Abschirmen von elektromagnetischem Interferenzrauschen und Betreiben des Lichtemitters (310) und des Lichtempfängers (320), während der transparente Elektrodentreiber (347) in einem zweiten Modus (M2) angetrieben wird, wenn bestimmt wird, dass der Diffusor (332) nicht beschädigt ist,
**dadurch gekennzeichnet, dass**
die transparente Elektrode (333) als der erste Modus gemäß einem ersten Modusantriebssignal angetrieben wird und als der zweite Modus (M2) gemäß einem zweiten Modusantriebssignal angetrieben wird,
wobei eine Beschädigung des Diffusors (332) unter Verwendung einer Spannung erfasst wird, die an die transparente Elektrode (333) in dem ersten Modus (M1) angelegt wird, und
wobei das elektromagnetische Interferenzrauschen durch Verbinden der transparenten Elektrode (333) mit einer Masse in dem zweiten Modus (M2) entfernt wird.

10. Bilderfassungsverfahren nach Anspruch 9, wobei bei dem Erfassen, ob der Diffusor (332) beschädigt ist, ein Modusschalter (347b) die transparente Elektrode mit einer Spannungsvergleichsschaltung (347c) verbindet, die konfiguriert ist, um eine Spannung, die an die transparente Elektrode (333) angelegt wird, mit einer Referenzspannung (VREF) zu vergleichen.

11. Bilderfassungsverfahren nach Anspruch 10, wobei bei dem Erfassen, ob der Diffusor (332) beschädigt ist, die Spannungsvergleichsschaltung (347c) die Spannung, die an die transparente Elektrode angelegt wird, mit der Referenzspannung (VREF) vergleicht, bestimmt, dass der Diffusor (332) nicht beschädigt ist, wenn die Spannung, die an die transparente Elektrode angelegt wird, kleiner als die Referenzspannung ist, und bestimmt, dass der Diffusor (332) beschädigt ist, wenn die Spannung, die an die transparente Elektrode angelegt wird, größer als die Referenzspannung ist.

12. Bilderfassungsverfahren nach einem der Ansprüche 9 bis 11, wobei bei dem Abschirmen von elektromagnetischem Interferenzrauschen und Betreiben des Lichtemitters (310) und des Lichtempfängers (320), während der transparente Elektrodentreiber (347) in dem zweiten Modus (M2) angetrieben wird, wenn bestimmt wird, dass der Diffusor (332) nicht beschädigt ist, ein Modusschalter (347b) die transparente Elektrode mit einer Masseleitung (347d) verbindet.

13. Bilderfassungsverfahren nach einem der Ansprüche 9 bis 12, wobei bei dem Erfassen, ob der Diffusor (332) beschädigt ist, unter Verwendung der transparenten Elektrode, die auf dem Diffusor (332) angeordnet ist, während der transparente Elektrodentreiber (347) in dem ersten Modus (M1) angetrieben wird, eine Steuerschaltung (347a) ein Spannungsvergleichsschaltungs(347c)-Verbindungssignal an einen Modusschalter (347b) ausgibt; und
wobei bei dem Abschirmen von elektromagnetischem Interferenzrauschen und Betreiben des Lichtemitters (310) und des Lichtempfängers (320), während der transparente Elektrodentreiber (347) in dem zweiten Modus (M2) angetrieben wird, wenn bestimmt wird, dass der Diffusor (332) nicht beschädigt ist, die Steuerschaltung (347a) ein Masseleitungsverbindungssignal an den Modusschalter (347b) ausgibt.

14. Bilderfassungsverfahren nach einem der Ansprüche 9 bis 13, wobei das Erfassen, ob der Diffusor (332) beschädigt ist, unter Verwendung der transparenten Elektrode, die auf dem Diffusor (332) angeordnet ist, während der transparente Elektrodentreiber (347) in dem ersten Modus (M1) angetrieben wird, das Vergleichen einer Referenzspannung (VREF) mit einer Spannung, die an die transparente Elektrode (333) angelegt wird, und das Erfassen, ob der Diffusor (332) beschädigt ist, unter Verwendung eines Komparators umfasst, der konfiguriert ist, um die Referenzspannung zu empfangen und die Spannung, die an die transparente Elektrode in dem ersten Modus (M1) angelegt wird, durch einen zweiten Eingangsanschluss zu empfangen.

## Revendications

1. Appareil de détection d'image (30), comportant :
un dispositif d'excitation (340) disposé sur un substrat (400) et configuré pour exciter un émetteur de lumière (310) et un récepteur de lumière (320) qui servent à des fins d'émission d'un premier signal optique vers un objet et de réception d'un deuxième signal optique réfléchi en provenance de l'objet ;
un boîtier (331) accouplé au substrat et entourant l'émetteur de lumière (310), le récepteur de lumière (320) et le dispositif d'excitation (340) ;
un diffuseur (332) disposé sur le boîtier (331) ; et
une électrode transparente (333) disposée sur le diffuseur (332),
dans lequel le dispositif d'excitation (340) comprend un dispositif d'excitation d'électrode transparente (347) configuré pour détecter si le diffuseur (332) est endommagé dans un premier mode (M1) et pour protéger le bruit d'interférence électromagnétique dans un deuxième mode (M2) au moyen de l'électrode transparente (333), **caractérisé en ce que** l'électrode transparente (333) est excitée dans le premier mode (M1) en fonction d'un signal d'excitation de premier mode, et excitée dans le deuxième mode (M2) en fonction d'un deuxième signal d'excitation,
dans lequel un dommage du diffuseur (332) est détecté au moyen d'une tension appliquée au niveau de l'électrode transparente (333) dans le premier mode (M1), et
dans lequel le bruit d'interférence électromagnétique est éliminé par la connexion de l'électrode transparente (333) à une masse dans le deuxième mode (M2).

2. Appareil de détection d'image selon la revendication 1, dans lequel, avant que l'émetteur de lumière (310) et le récepteur de lumière (320) ne soient initialisés et excités, le dispositif d'excitation d'électrode transparente (347) est excité dans le premier mode (M1) pour comparer une tension appliquée au niveau de l'électrode transparente (333) à une tension de référence (VREF) ; et pour déterminer si le diffuseur (332) est endommagé ;
dans lequel, quand il est déterminé que le diffuseur (332) est endommagé, l'émetteur de lumière (310) et le récepteur de lumière (320) cessent de fonctionner ; et
dans lequel, quand il est déterminé que le diffuseur (332) n'est pas endommagé, le dispositif d'excitation d'électrode transparente (347) est excité dans le deuxième mode (M2).

3. Appareil de détection d'image selon l'une quelconque des revendications précédentes, dans lequel le dispositif d'excitation d'électrode transparente (347) comprend :
un circuit de comparaison de tension (347c) configuré pour détecter si le diffuseur (332) est endommagé ;
une ligne de masse (347d) reliée à la masse ;
un commutateur de mode (347b) configuré pour connecter l'électrode transparente à l'un quelconque parmi le circuit de comparaison de tension (347c) et la ligne de masse (347d) en fonction d'un mode d'excitation ; et
un circuit de commande (347a) configuré pour commander le commutateur de mode (347b) afin de connecter l'électrode transparente à l'un quelconque parmi le circuit de comparaison de tension (347c) et la ligne de masse (347d) en fonction du mode d'excitation.

4. Appareil de détection d'image selon la revendication 3, dans lequel, dans le premier mode (M1), le circuit de commande (347a) commande le commutateur de mode (347b) pour connecter l'électrode transparente (333) au circuit de comparaison de tension (347c), et le circuit de comparaison de tension (347c) émet en sortie, au circuit de commande (347a), un résultat de comparaison obtenu en comparant une tension appliquée au niveau de l'électrode transparente (333) à une tension de référence (VREF) ; et
dans lequel, quand la tension appliquée au niveau de l'électrode transparente (333) est inférieure à la tension de référence (VREF), le circuit de commande (347a) détermine que le diffuseur (332) n'est pas endommagé et excite le dispositif d'excitation d'électrode transparente dans le deuxième mode (M2) à des fins de protection contre le bruit d'interférence électromagnétique ; et
dans lequel, quand la tension appliquée au niveau de l'électrode transparente (333) est supérieure à la tension de référence, le circuit de commande (347a) détermine que le diffuseur (332) est endommagé et arrête toutes les opérations de l'émetteur de lumière (310) et du récepteur de lumière (320).

5. Appareil de détection d'image selon la revendication 3 ou la revendication 4, dans lequel, dans le deuxième mode, le circuit de commande (347a) commande le commutateur de mode (347b) pour connecter l'électrode transparente (333) à la ligne de masse (347d).

6. Appareil de détection d'image selon l'une quelconque des revendications 3 à 5, dans lequel le circuit de comparaison de tension (347c) comprend un comparateur configuré pour recevoir une tension de référence (VREF) par l'intermédiaire d'une première borne d'entrée, pour recevoir une tension appliquée au niveau de l'électrode transparente (333) dans le premier mode par l'intermédiaire d'une deuxième borne d'entrée, pour comparer la tension de référence (VREF) à la tension appliquée au niveau de l'électrode transparente, et pour émettre en sortie un résultat de comparaison au circuit de commande (347a).

7. Appareil de détection d'image selon l'une quelconque des revendications 3 à 6, dans lequel un premier circuit unitaire (UC1) comprend le circuit de commande (347a), le circuit de comparaison de tension (347c), le commutateur de mode (347b) et la ligne de masse (347d) ; et
dans lequel le premier circuit unitaire (UC1) est mis en œuvre sous la forme d'un circuit monté sur une puce de circuit intégré ou une carte de circuit imprimé.

8. Appareil de détection d'image selon l'une quelconque des revendications 3 à 7, dans lequel un premier circuit unitaire (UC1) comprend le circuit de commande (347a) et le circuit de comparaison de tension (347c) ; dans lequel un deuxième circuit unitaire (UC2) comprend le commutateur de mode (347b) et la ligne de masse (347d) ; et dans lequel le premier circuit unitaire (UC1) est mis en œuvre sous la forme d'un circuit monté sur une puce de circuit intégré ou une carte de circuit imprimé, et le deuxième circuit unitaire (UC2) est mis en œuvre sous la forme d'un circuit monté sur une autre puce de circuit intégré ou une autre carte de circuit imprimé.

9. Procédé de détection d'image comportant les étapes consistant à :
initialiser un émetteur de lumière (310) et un récepteur de lumière (320) ;
détecter si un diffuseur (332) est endommagé au moyen d'une électrode transparente (333) disposée sur le diffuseur (332) quand le dispositif d'excitation d'électrode transparente (347) est excité dans un premier mode (M1) ;
arrêter toutes les opérations de l'émetteur de lumière (310) et du récepteur de lumière (320) quand il est déterminé que le diffuseur (332) est endommagé ; et
protéger contre bruit d'interférence électromagnétique et faire fonctionner l'émetteur de lumière (310) et le récepteur de lumière (320) quand le dispositif d'excitation d'électrode transparente (347) est excité dans un deuxième mode (M2) quand il est déterminé que le diffuseur (332) n'est pas endommagé,
**caractérisé en ce que** l'électrode transparente (333) est excitée dans le premier mode en fonction d'un premier signal d'excitation de mode, et excitée dans le deuxième mode (M) en fonction d'un deuxième signal d'excitation de mode,
dans lequel un dommage du diffuseur (332) est détecté au moyen d'une tension appliquée au niveau de l'électrode transparente (333) dans le premier mode (M1), et
dans lequel le bruit d'interférence électromagnétique est éliminé par la connexion de l'électrode transparente (333) à une masse dans le deuxième mode (M2).

10. Procédé de détection d'image selon la revendication 9, dans lequel, lors de l'étape consistant à détecter si le diffuseur (332) est endommagé, un commutateur de mode (347b) connecte l'électrode transparente à un circuit de comparaison de tension (347c) configuré pour comparer une tension appliquée au niveau de l'électrode transparente (333) à une tension de référence (VREF).

11. Procédé de détection d'image selon la revendication 10, dans lequel, lors de l'étape consistant à détecter si le diffuseur (332) est endommagé, le circuit de comparaison de tension (347c) compare la tension appliquée au niveau de l'électrode transparente à la tension de référence (VREF), détermine que le diffuseur (332) n'est pas endommagé quand la tension appliquée au niveau de l'électrode transparente est inférieure à la tension de référence, et détermine que le diffuseur (332) est endommagé quand la tension appliquée au niveau de l'électrode transparente est supérieure à la tension de référence.

12. Procédé de détection d'image selon l'une quelconque des revendications 9 à 11, dans lequel, lors de l'étape consistant à protéger contre le bruit d'interférence électromagnétique et de l'étape consistant à faire fonctionner l'émetteur de lumière (310) et le récepteur de lumière (320) quand dispositif d'excitation d'électrode transparente (347) est excité dans le deuxième mode (M2) quand il est déterminé que le diffuseur (332) n'est pas endommagé, un commutateur de mode (347b) connecte l'électrode transparente à une ligne de masse (347d).

13. Procédé de détection d'image selon l'une quelconque des revendications 9 à 12, dans lequel, lors de l'étape consistant à détecter si le diffuseur (332) est endommagé au moyen de l'électrode transparente disposée sur le diffuseur (332) quand le dispositif d'excitation d'électrode transparente (347) est excité dans le premier mode (M1), un circuit de commande (347a) émet en sortie un signal de connexion de circuit de comparaison de tension (347c) à un commutateur de mode (347b) ; et
dans lequel, lors de l'étape consistant à protéger contre le bruit d'interférence électromagnétique et de l'étape consistant à faire fonctionner l'émetteur de lumière (310) et le récepteur de lumière (320) quand le dispositif d'excitation d'électrode transparente (347) est excité dans le deuxième mode (M2) quand il est déterminé que le diffuseur (332) n'est pas endommagé, le circuit de commande (347a) émet en sortie un signal de connexion de ligne de masse au commutateur de mode (347b).

14. Procédé de détection d'image selon l'une quelconque des revendications 9 à 13, dans lequel l'étape consistant à détecter si le diffuseur (332) est endommagé au moyen de l'électrode transparente disposée sur le diffuseur (332) quand le dispositif d'excitation d'électrode transparente (347) est excité dans le premier mode (M1) comprend les étapes consistant à comparer une tension de référence (VREF) à une tension appliquée au niveau de l'électrode transparente (333) et à détecter si le diffuseur (332) est endommagé au moyen d'un comparateur configuré pour recevoir la tension de référence et recevoir la tension appliquée au niveau de l'électrode transparente dans le premier mode (M1) par l'intermédiaire d'une deuxième borne d'entrée.
